Europäisches Patentamt

European Patent Office

Office européen des brevets

(11) Publication number: **0 405 205 A2**

# EUROPEAN PATENT APPLICATION

(21) Application number: 90110905.8

(22) Date of filing: 08.06.90

(51) Int. Cl.⁵: **H01L 21/316**, H01L 21/28

(30) Priority: 12.06.89 JP 149075/89
25.04.90 JP 109703/90

(43) Date of publication of application:
02.01.91 Bulletin 91/01

(84) Designated Contracting States:
DE FR GB

(71) Applicant: SEIKO INSTRUMENTS INC.
31-1, Kameido 6-chome Koto-ku
Tokyo 136(JP)

(72) Inventor: Inoue, Naoto, c/o Seiko Instruments Inc.
31-1, Kameido 6-chome, Koto-ku
Tokyo(JP)

(74) Representative: Fleuchaus, Leo, Dipl.-Ing. et al
Melchiorstrasse 42
D-8000 München 71(DE)

(54) Method of producing MOS type semiconductor device.

(57) In production of a gate oxide film of the MOS type semiconductor device, oxygen is added with trichloroethane to effect oxidation at a temperature from 1000°C to 1100°C so as to suppress generation of electron trap in the oxide film and interface trap which would be caused when electrons are injected into the oxide film. Alternatively, gas containing chlorine is dissociated to form a polysilicon gate electrode of the MOS type semiconductor device, and thereafter the chlorine is diffused into a gate oxide film by heating process, thereby suppressing generation of electron trap in the oxide film and generation of interface trap caused by injection of electrons into the oxide film.

# FIG. 1

EP 0 405 205 A2

# METHOD OF PRODUCING MOS TYPE SEMICONDUCTOR DEVICE

## Background of the Invention

The present invention relates to method of making a thermally oxidized silicondioxide film hereinafter, referred to as "SiO$_2$ film" which features less electron trap. The present invention also relates to a semiconductor device having less electron traps in an insulating film.

Conventionally, wet oxidation or dry oxidation is utilized generally for production method of gate oxide film in the MOS type semiconductor device.

However, the oxide film formed by the conventional oxidation method has many electron traps in the film, and many interface traps may be generated between the oxide film and a substrate due to injection of electrons into the film. When such method is applied to the making of nonvolatile memory of the floating gate type, electrons are captured by the oxide trap in the film and the interface trap on the film to cause reduction of possible writing-erasing cycle number of the memory.

Conventionally, a gate electrode of the MOS type semiconductor device is composed of polysilicon formed by CVD method utilizing SiH$_4$, i.e., silane.

The conventional MOS type semiconductor device utilizing the thus formed polysilicon gate electrode has many electron traps in the oxide film and generates many interface trap between the oxide film and the substrate due to injection of electrons into the film. When applying such device to a memory transistor of the floating gate type, electrons are captured in the oxide film and on the interface trap, thereby causing reduction of possible cycle number of writing and erasing of memory.

## Summary of the Invention

An object of the present invention is to produce a semiconductor device having reduced oxide trap and interface trap. According to first aspect of the invention, in order to reduce electron trap in the oxide film and to suppress the generation of interface trap due to injection of electrons into the oxide film, thermally oxidized silicondioxide film of the MOS type semiconductor device is formed in oxygen gas mixed with trichloroethane at a temperature from 1000° C to 1100° C.

The MOS type semiconductor device formed by the inventive method has less number of electron traps in the gate oxide film and less number of interface trap caused by electron injection, thereby reducing time-dependent degradation of the MOS type semiconductor device such as change of threshold voltage of transistor.

According to second aspect of the present invention, in order to reduce electron trap in the gate oxide film of the MOS type semiconductor device and to suppress generation of interface trap due to injection of electrons into the oxide film, a polysilicon gate electrode is formed with using chlorine-containing gas such as SiH$_2$C$\ell_2$ and SiC$\ell_4$, and thereafter chlorine is diffused into the oxide film by heating treatment.

The MOS type semiconductor device formed according to the second aspect of the invention has reduced number of electron traps in the gate oxide film and reduced number of interface traps caused by injection of electrons, thereby reducing time-dependent degradation of MOS type semiconductor device, for example, change of transistor threshold voltage.

Alternatively, the heating treatment is undertaken within ambient gas containing chlorine after formation of the gate oxide film to introduce therein chlorine effective to reduce electron trap.

## Brief Description of the Invention

Fig. 1 is a structural sectional view of the Si N channel transistor of the MOS type;
Fig. 2 is a diagram showing the relation between heating temperature and number of electrons trapped in SiO$_2$ film and interface trap;
Fig. 3 is a structural sectional view of the memory transistor of the floating gate type;
Figs. 4A and 4B are a diagram showing fabrication steps of the N channel silicon MOS type transistor;
Fig. 5 is a graph showing the relation between TCA concentration and transistor threshold value shift;
Figs. 6A - 6C are a diagram showing fabrication steps of the floating gate type memory transistor;
Fig. 7 is a graph showing the relation between heating treatment temperature after formation of polysilicon gate electrode and voltage shift of C - V curve;

2

Fig. 8 is a structural sectional view of the N channel MOS type silicon semiconductor device;

Fig. 9 is a structural sectional view of the floating gate type memory transistor;

Figs. 10A - 10C are a diagram showing fabrication steps of N channel silicon MOS type transistor;

Figs 11A - 11D are a diagram showing fabrication steps of the floating gate type memory transistor; and

Fig. 12 is a graph showing the relation between heating treatment temperature and voltage shift of C - V curve.

## Detailed Description of the Invention

### Embodiment 1

This embodiment is directed to Si N channel MOS type transistor in which the $SiO_2$ film formed according to the invention is utilized as a gate oxide film.

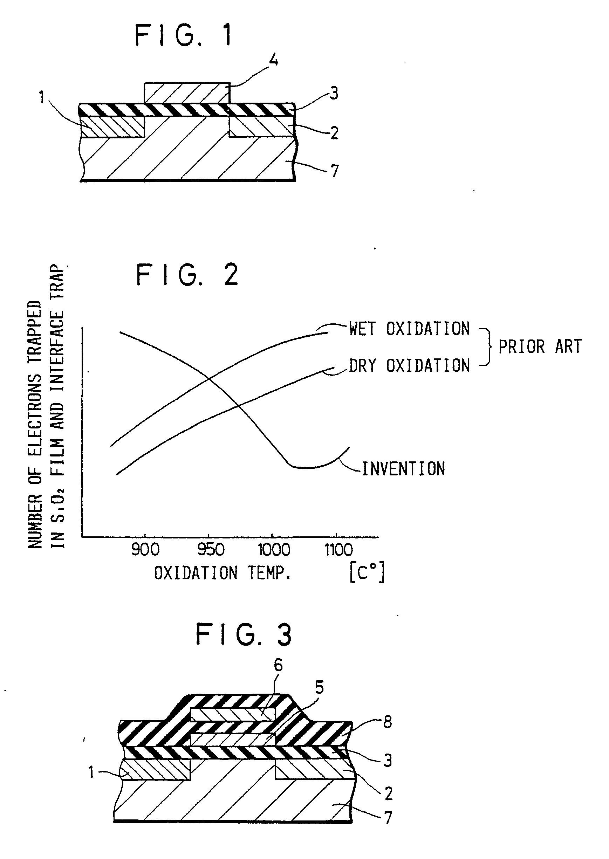

Fig. 1 is a structural sectional view of the Si N channel MOS type transistor. The Si N channel MOS type transistor is formed such that $N^+$ source region 1 and $N^+$ drain region 2 are formed on a P type Si substrate 7 to define therebetween a P type channel region, and thereafter a gate oxide film 3 and a gate electrode 4 are formed sequentially.

In this embodiment, the gate oxide film 3 is formed by oxidizing a surface of the P type silicon substrate 7, such that thermal oxidation is effected within ambient gas mixture of oxygen and TCA carried by nitrogen at the mixing ratio of $O_2/TCA$ = 3.0 - 4.0 so as to form $SiO_2$ film at thickness of 100 Å.

Fig. 2 is a graph showing the relation between heating temperature in forming of the $SiO_2$ film and number of electrons captured in the formed $SiO_2$ film and in the interface trap. As shown in Fig. 2, the oxidation temperature has an optimum range from 1000 °C to 1100 °C. Fig. 2 also shows comparable data in connection with the conventional method of wet oxidation and dry oxidation. According to the inventive method, number of electrons captured by the oxide trap in the formed $SiO_2$ film and by the interface trap is smaller than those in the conventional cases, thereby reducing degradation of the semiconductor device with the passage of time. Further, TCA gas can be diluted by carrier gas of nitrogen according to rate of oxidation.

### Embodiment 2

This embodiment is directed to a memory transistor of the floating gate type in which the $SiO_2$ film according to the inventive method is utilized as a gate oxide film of a transistor. Fig. 3 is a sectional view of the floating gate type memory transistor. $N^+$ source region 1 and $N^+$ drain region 2 are formed on a P type Si substrate 7 to define therebetween p type channel region. Then, oxidation of the substrate surface is undertaken within ambient gas composed of mixture of oxigen and TCA carried by nitrogen gas and having the mixture ratio $O_2/TCA$ = 3.0 at 1050 °C to form 120 Å thickness of $SiO_2$ film as the gate oxide film 3. A floating gate electrode 5 is formed of polysilicon on the gate oxide film 3, then a control gate electrode 6 is formed of polysilicon in superposed relation through an insulating layer 8, and thereafter the substrate is overcoated with another insulating layer 8 to thereby make the floating gate type memory transistor. This floating gate type memory transistor has relatively small number of electrons captured by the dioxide trap and interface trap, thereby achieving sufficient cycle number of writing and erasing of memory.

As discribed above, according to the first aspect of the present invention, the electron trap in the gate oxide film and the interface trap generated when electrons are injected into the oxide film are reduced so as to suppress change of transistor threshold voltage with the passage of time and mis-operation of the memory transistor.

### Embodiment 3

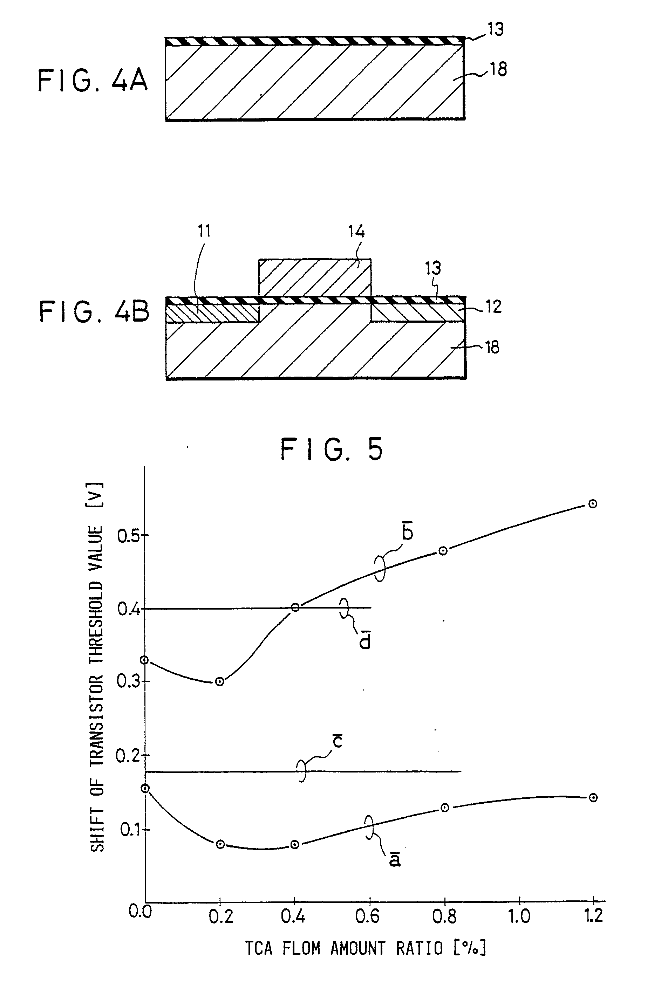

In this embodiment, $SiO_2$ film of reduced electron traps is formed as a gate oxide film of silicon N channel MOS type transistor. In the step of Fig. 4A, a gate oxide film 13 is formed on a P type silicon substrate 18 over a P type channel region. In the step of Fig. 4B, $N^+$ type source region 11 and $N^+$ type drain region 12 are formed by ion doping through the gate oxide film 13 with using a gate electrode 14 as a mask. In this embodiment, the gate oxide 13 is formed by thermal oxidation in ambient gas containing TCA diluted by carrier nitrogen at the flow amount ratio of less than 0.8 %. This flow amount ratio or the TCA concentration (%) is determined according to the following relation:

$$\frac{\text{TCA vapor pressure}}{760 \text{ mm Hg}} \times \frac{\text{Bubbler flow rate}}{\text{Total flow rate}}$$

Fig. 5 is a diagram showing the relation between the thus determined TCA flow amount ratio and shift or drift of transistor threshold value indicative of ratio of electrons trapped in the oxide film and on the interface thereof. As shown by the curve $\bar{a}$ , the TCA flow amount ratio is set less than 0.8% elective to reduce the ratio of electrons trapped in the oxide film and on the interface. On the other hand, as shown by the curve $\bar{c}$ , when producing the oxide film according to the conventional wet or dry oxidation method, the gate oxide film has many electron traps and generates interface trap between the oxide film and the substrate surface due to injection of electrons into the oxide film. The data shown in the Fig. 5 graph by curve $\bar{a}$ is measured with respect to a sample in which the dry oxidation is carried out within TCA-containing ambient gas at 1000°C. The same effect can be obtained in the rauge from 950°C to 1100°C.

## Embodiment 4

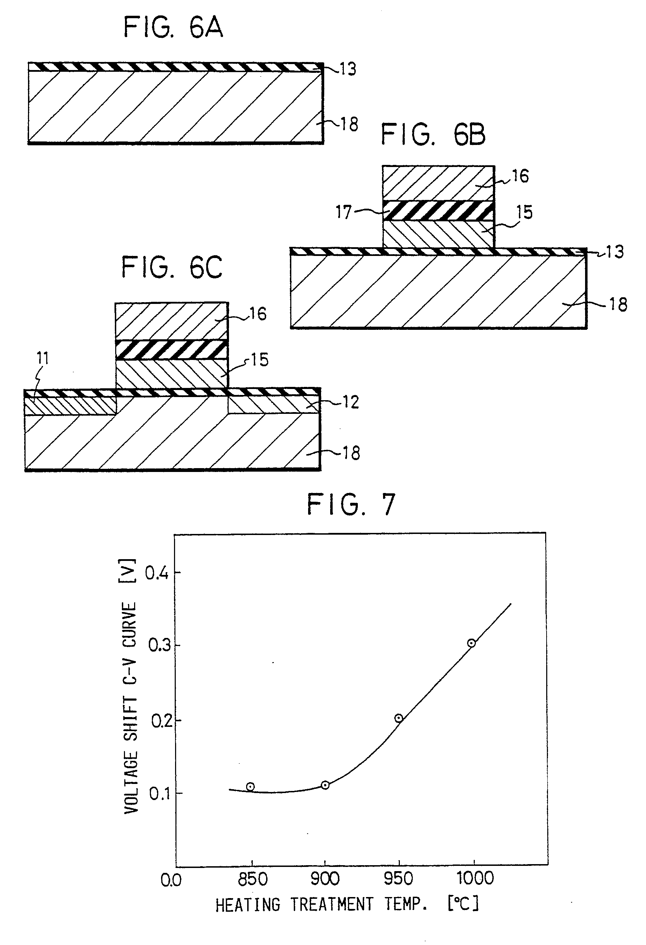

In this embodiment, an $SiO_2$ film having less electron traps is formed as a gate oxide film of the silicon floating gate type memory transistor. In the step shown in Fig. 6A, a gate oxide film 13 is formed on a P type silicon substrate 18 over a p type cannel region. In the Fig. 6B step, a control gate electrode 16 is formed over a floating gate electrode 15 through an insulating layer 17. In the Fig. 6C step, $N^+$ source region 11 and $N^+$ drain region 12 are formed by ion doping through the gate oxide film with using as a mask the floating gate electrode 15 and the control gate electrode 16. Then, heating treatment is undertaken at 950°C -1000°C after the formation of the control gate electrode in the floating gate type memory transistor.

Fig. 7 is a diagram showing the relation between the heating treatment temperature after the formation of polysilicon gate electrode and the voltage shift of C - V curve, indicative of rate of electrons trapped in the oxide film and on the interface thereof. As shown in Fig. 7, the rate of tapped electrons increases in the higher range of the heating treatment temperature.

Referring back to Fig. 5, as shown by the curve $\bar{b}$ , in this embodiment 4, the gate oxidation is undertaken within the TCA-containing ambient gas which contains TCA carried by nitrogen at the flow amount ratio of less than 0.4% effective to reduce trapping rate of electrons in the oxide film and on the interface thereof. On the other hand, as shown by the curve d, when applying heating treatment to the comparable conventional device after the formation of the gate electrode, the device is further degradated.

The gate electrode is composed of polysilicon in this embodiment. However, the gate electrode can be formed of silicide or polycide.

## Embodiment 5

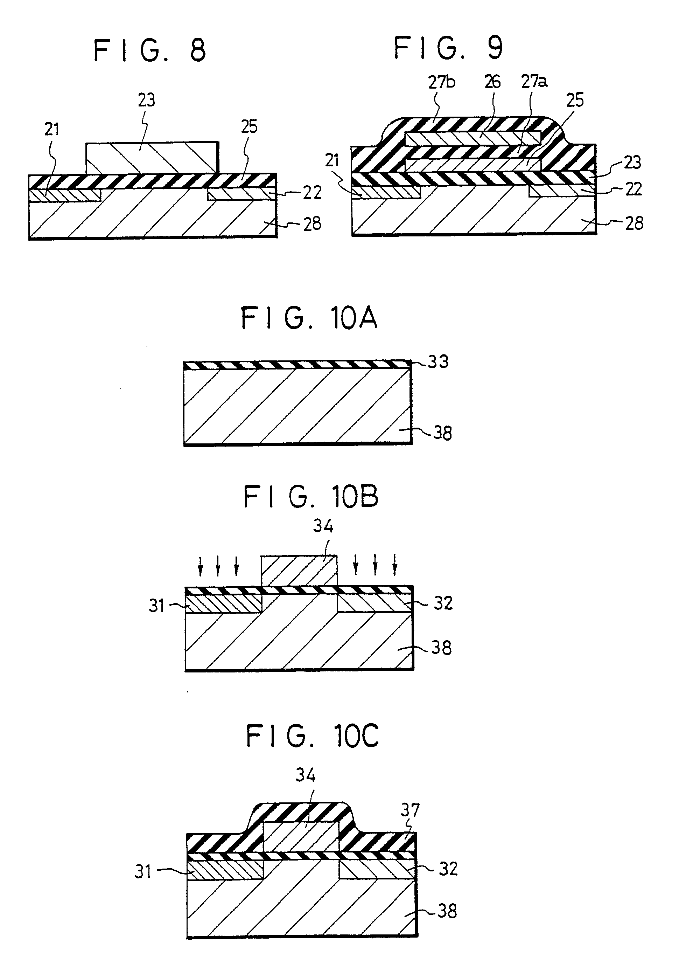

The present embodiment is directed to N channel MOS type silicon semiconductor device in which a polysilicon gate electrode formed according to the invention is utilized. Fig. 8 is a structural sectional view of the N channel MOS type silicon semiconductor device. $N^+$ source region 21 and $N^+$ drain region 22 are formed on a P type silicon substrate 28 to define therebetween a P type channel region, and gate insulating film 25 is formed thereafter. Next, a gate electrode 23 is formed of polysilicon by thermal dissociation of $SiH_2Cl_2$ at 800°C - 1000°C, and then thermal treatment is undertaken at 800°C -1100°C to diffuse chlorine into the oxide film.

## Embodiment 6

4

This embodiment is directed to a memory transistor of the floating gate type in which a polysilicon film formed according to the invention is utilized as a gate electrode. Fig. 9 is a sectional view of the memory transistor of floating gate type. An $N^+$ source region 21 and $N^+$ drain region 22 are formed on a P type silicon substrate 28 to define therebetween P type channel region, and a gate insulating film 23 is formed thereafter. A floating gate electrode 25 is formed on the insulating film by thermal dissociation of $SiCl_4$ at 900°C - 1000°C, and then heating treatment is carried out at 800°C - 1000°C in manner similar to the previous embodiment 5 so as to diffuse or introduce chlorine into the insulating oxide film. Next, a control gate electrode 26 is formed of polysilicon through an insulating layer 27a in multi-layer structure, which is then overcoated by another insulating layer 27b to thereby produce the memory transistor of floating gate type.

As described above, according to the second aspect of the present invention, the electron traps in the gate oxide film and interface traps due to injection of electrons into the oxide film can be reduced to lower number of trapped electrons, thereby effectively suppressing time-dependent change of transistor threshold voltage and mis-operation of memory transistor. $SiH_2Cl_2$ and $SiCl_4$ are used in the embodiments; however, $SiHCl_3$ may be used to achieve the same effect. The source gas is thermally dissociated in the embodiments; however, plasma dissociation or photo-dissociation can be adopted to achieve the same effect.

## Embodiment 7

In this embodiment, a silicon N channel MOS type semiconductor device is formed as shown in Fig. 10A -10C. In the step of Fig. 10A, a gate oxide film 33 is formed on a P type silicon substrate 38 over a P type channel region. In the step of Fig. 10B, $N^+$ channel source region 31 and $N^+$ drain region 32 are formed by ion doping through the gate oxide film 33 with using a gate electrode 34 as a mask. In the step of Fig. 10C, after forming an insulating layer 37, heating treatment is undertaken at 850°C - 1000°C within ambient gas composed of oxygen containing TCA. When effecting the heating treatment within oxygen gas containing chlorine or Fluorine, the gate electrode may be oxidized by the oxygen to reduce thickness of the gate electrode. In order to avoid such phenomenon, the oxygen should be diluted by nitrogen. In such case, the mixing ratio of TCA and oxygen is preferably set to $O_2/TCA$ = 3.0 through 4.0.

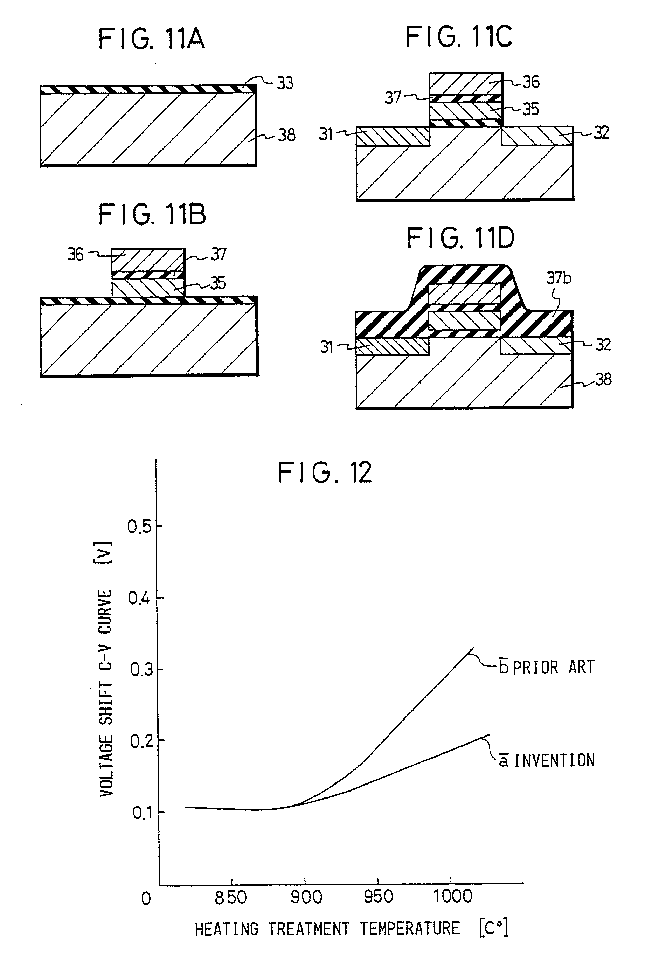

Fig. 12 shows the relation between the heating treatment temperature and voltage shift of C - V curve in the semiconductor device, which is indicative of degree of electron trap in the oxide film and on the interface thereof. The curve $\bar{a}$ represents the result of the invention, which is superior to the result of the prior art as indicated by the curve $\bar{b}$ . In the prior art, the heating treatment is carried out within ambient inert gas composed of nitrogen or argon after the formation of gate electrode in the MOS type semiconductor device. In such case, number of trapped electrons increases at a temperature about 900°C in the oxide film and on the interface.

## Embodiment 8

In this embodiment, the floating memory transistor is formed as shown in Fig. 11A - 11D. In the Fig. 11A step, a gate oxide film 33 is formed on a P type silicon substrate 38 over a P type channel region. In the Fig. 11B step, a floating gate electrode 35 is formed, and thereafter a control gate electrode 36 is formed thereon to sandwich an insulating layer 37. In the Fig. 11C step, $N^+$ source region 31 and $N^+$ drain region 32 are formed by ion doping through the gate oxide film with using the superposed gate electrodes as a mask. In the Fig. 11D step, after forming another insulating layer 37b, heating treatment is undertaken at 850°C - 1000°C within ambient oxygen gas containing HCl so as to introduce chlorine into the gate oxide film to reduce electron traps.

In these embodiments, TCA and HCl are utilized; however, trichloroetherne TCE or trifluoronitrogen $NF_3$ can be used instead of them.

## Claims

1. A method of making a semiconductor device of the MOS type; wherein thermal oxidation is conducted in mixture gas of oxygen mixed with trichloroethane to form a gate insulating film composed of thermally oxidized silicondioxide.

2. A method according to claim 1; wherein the thermal oxidation is undertaken at a temperature in the range from 1000°C to 1100°C.

3. A method according to claim 1; wherein the mixture gas contains less than 0.8% of trichloroethane when making a semiconductor device of the MOS transistor.

4. A method according to claim 1; wherein the mixture gas contains less than 0.4% of trichloroethane when making a semiconductor device of the MOS floating gate memory transistor.

5. A method of producing a MOS type semiconductor device having a channel region of one conductivity type, a pair of source region and drain region of opposite conductivity type spaced from each other at opposite ends of the channel region, a gate insulating film formed on the channel region, and a gate electrode formed on the gate insulating film; the method wherein a gate electrode of polysilicon is formed by dissociation of gas containing chlorine, and the chlorine is diffused into the gate insulating film by heating after formation of the gate electrode.

6. A method of producing a MOS type semiconductor device having a channel region of one conductivity type, a pair of source region and drain region of opposite conductivity type spaced from each other at opposite ends of the channel region, a gate insulating film formed on the channel region, and a gate electrode formed on the gate insulating film, the method wherein heating treatment is undertaken after forming the gate electrode within ambient gas containing chlorine or fluorine so as to diffuse chlorine or fluorine into the gate insulating film.

7. A semiconductor device of the MOS type comprising:
a channel region of one conducitvity type 3;
a pair of source region and drain region of opposite conductivity type spaced from each other at opposite ends of the channel region;
a gate insulation film formed of silicon dioxide containing chlorine on the channel region; and
a gate electrode formed on the gate insulating film.

# FIG. 1

# FIG. 2

NUMBER OF ELECTRONS TRAPPED IN $S_iO_2$ FILM AND INTERFACE TRAP

WET OXIDATION

DRY OXIDATION

} PRIOR ART

INVENTION

OXIDATION TEMP. [C°]

# FIG. 3

FIG. 4A

13
18

FIG. 4B

11
14
13
12
18

# FIG. 5

SHIFT OF TRANSISTOR THRESHOLD VALUE [V]

$\bar{b}$

$\bar{d}$

$\bar{c}$

$\bar{a}$

TCA FLOM AMOUNT RATIO [%]

## FIG. 6A

## FIG. 6B

## FIG. 6C

## FIG. 7

# FIG. 8

# FIG. 9

# FIG. 10A

# FIG. 10B

# FIG. 10C

# FIG. 11A

33

38

# FIG. 11B

36

37

35

# FIG. 11C

37

36

35

31

32

# FIG. 11D

37b

31

32

38

# FIG. 12

VOLTAGE SHIFT C-V CURVE [V]

0.5

0.4

0.3 — б PRIOR ART

0.2 — ā INVENTION

0.1

0    850    900    950    1000

HEATING TREATMENT TEMPERATURE [C°]